# EUROPEAN PATENT APPLICATION

(11) **EP 2 012 344 A1**
(43) Date of publication of application: **07.01.2009**
(21) Application number: 08075517.6
(22) Date of filing: 28.05.2008
(51) Int. Cl.: H01L 21/00

(54) **A method for picking up a component as well as a device suitable for carrying out such a method**

(30) Priority: 03.07.2007 NL 1034087
(71) Applicant: Assembléon B.V., 5503 LA Veldhoven (NL)
(72) Inventor: Wesseling, Wessel Joris, 5502 PB Veldhoven (NL)
(74) Representative: Dorna, Peter

(57) **Abstract**

A method for picking up a component from a film. The component is connected to the film by means of an adhesive bond, which adhesive bond between the component and the film is irradiated by means of an energy beam. Prior to the irradiation of the adhesive bond by means of the energy beam, a nozzle is placed into contact with the component on a side remote from the film by moving part of the film in the direction of the nozzle, after which the energy beam, which comprises a laser beam, is activated. The adhesive bond between the component and the film is at least substantially completely broken by the energy source. Following that, the component is picked up from the film by means of the nozzle.

## Description

The invention relates to a method for picking up a component from a film, which component is connected to the film by means of an adhesive bond, which adhesive bond between the component and the film is irradiated by means of an energy beam, after which the component is picked up from the film by means of a nozzle.

The invention also relates to a device suitable for carrying out such a method, which device comprises a carrier for a film provided with components, which components are connected to the film by means of an adhesive bond, which device further comprises a nozzle for picking up a component from the film as well as a light source for generating an energy beam for irradiating the adhesive bond.

With such a method and device, which are known from European patent EP-B1-0 431 637, the adhesive bond between the component and the film is weakened by means of an ultraviolet energy beam, after which the component is engaged by means of the nozzle and peeled from the film.

During said operation, pins are placed into contact with the film on a side remote from the components, after which the component is pushed up from the film.

A drawback of the known method is that as increasingly smaller components are being used, for example components measuring 0.3 x 0.3 mm and having a thickness of 0.003 mm, the use of such pins is quite complicated. Moreover, since the adhesive bond is only weakened, a force needs to be exerted on the component by means of the nozzle so as to break the adhesive bond completely.

The object of the invention is to provide a method by means of which components can be picked up from a film in a simple and reliable manner.

This object is accomplished with the method according to the invention in that prior to the irradiation of the adhesive bond by means of the energy beam, the nozzle is placed into contact with the component on a side remote from the film by moving part of the film in the direction of the nozzle, after which the energy beam, which comprises a laser beam, is activated, so that the adhesive bond between the component and the film is irradiated by the energy beam and the adhesive bond is at least substantially completely broken.

The laser beam breaks the adhesive bond at least substantially completely, causing the component to become detached from the film. However, because the nozzle was placed into contact with the component prior to the activation of the laser beam, the component is immediately picked up by the nozzle and can subsequently be moved away from the film by the nozzle. Since the adhesive bond between the component and the film is completely or at least substantially completely broken, the nozzle hardly needs to exert a force on the component for detaching the component from the film. Moreover, there is no need for any pins on a side of the film remote from the component.

By moving part of the film in the direction of the nozzle, said part of the film is slightly stretched, as a result of which the components present on said part of the film are moved slightly apart. In this way the removal of a component will not be impeded by possible contact of said component with adjacent components.

One embodiment of the method according to the invention is characterised in that the component is pushed away from the film, into contact with the nozzle, as a result of the laser beam being activated.

The adhesive bond between component and film is completely broken by the laser energy, and the component is pressed firmly against the nozzle. The component can be held in contact with the nozzle by means of a partial vacuum applied by the nozzle, for example. The nozzle prevents the component in a simple manner from being shot off the film by the energy introduced into the adhesive bond by the laser beam, which would result in control over the component being lost.

Another embodiment of the method according to the invention is characterised in that the laser beam is activated for 10-50 milliseconds, during which period 10 -20 Watt is introduced into the adhesive bond.

It has been found that it suffices to apply a relatively high power of a few dozen Watts to the adhesive bond for a relatively very short time of a few milliseconds, so that the film and the adhesive bond will start to bubble and the component is moved away from the film. The component is then stopped, caught, engaged and moved by the nozzle.

Yet another embodiment of the method according to the invention is characterised in that a number of components are picked up in succession by means of a number of nozzles, after which the components are placed on at least one substrate.

In this way it is possible to pick up a number of components in a relatively short time, after which the components can be placed on a substrate. This can be done by means of the same nozzle as used for picking up the component from the film. It is also possible, however, to transfer the component from the nozzle to another device, by means of which the component is subsequently placed on the substrate.

The invention also relates to a device suitable for carrying out the method according to the invention, which device is characterised in that the light source is a laser for generating a laser beam, which device further comprises a ring extending around a central axis, which can be positioned on a side of the film remote from the components, with the central axis extending substantially transversely to the film, which ring is movable in a direction parallel to said central axis.

Using a laser beam, a relatively large amount of energy can be introduced into an adhesive bond between the component and the film in a relatively short period of time, as a result of which the adhesive bond is completely or substantially completely broken. By moving part of the film in the direction of the nozzle by means of the ring, said part of the film is slightly stretched, as a result of which the components present on said part are moved slightly apart. In this way the removal of a component is not impeded by possible contact of said component with adjacent components.

The invention will now be explained in more detail with reference to the drawings, in which:
Figure 1 is a perspective view of a number of components connected to a film;
Figure 2 shows nine steps of the method according to the invention;
Figures 3-10 are side elevations of a device according to the invention, showing the picking up of a component and the placement thereof on a substrate.

Like parts are indicated by the same numerals in the figures.

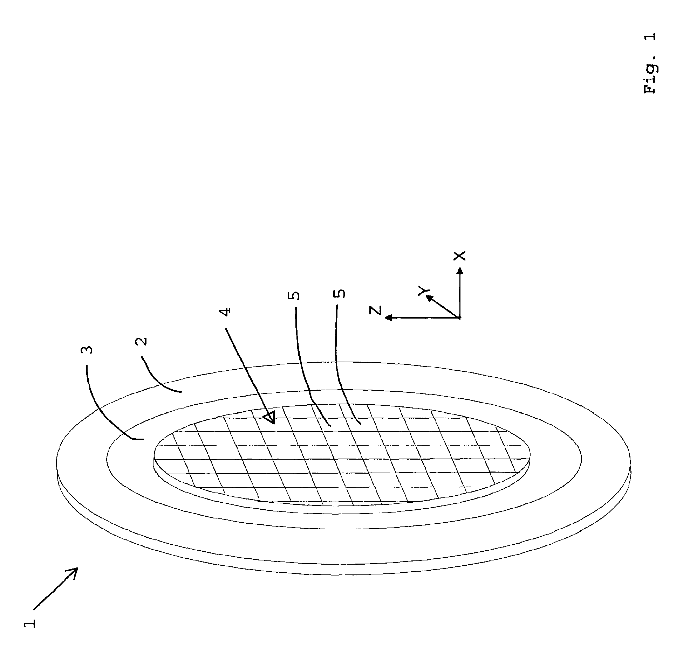

Figure 1 shows a component carrier 1 provided with a ring 2 and a film 3 stretched thereon by the ring 2. Connected to the film 3, by means of an adhesive, is a wafer 4 comprising a plurality of components 5. Such a component carrier 1 is known per se and will not be explained in more detail herein, therefore.

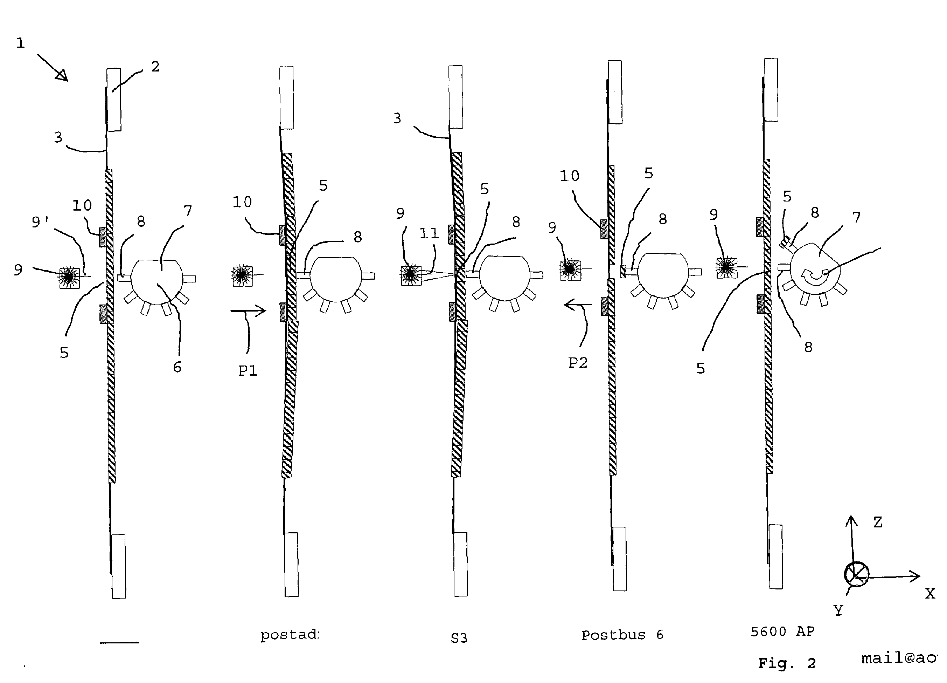

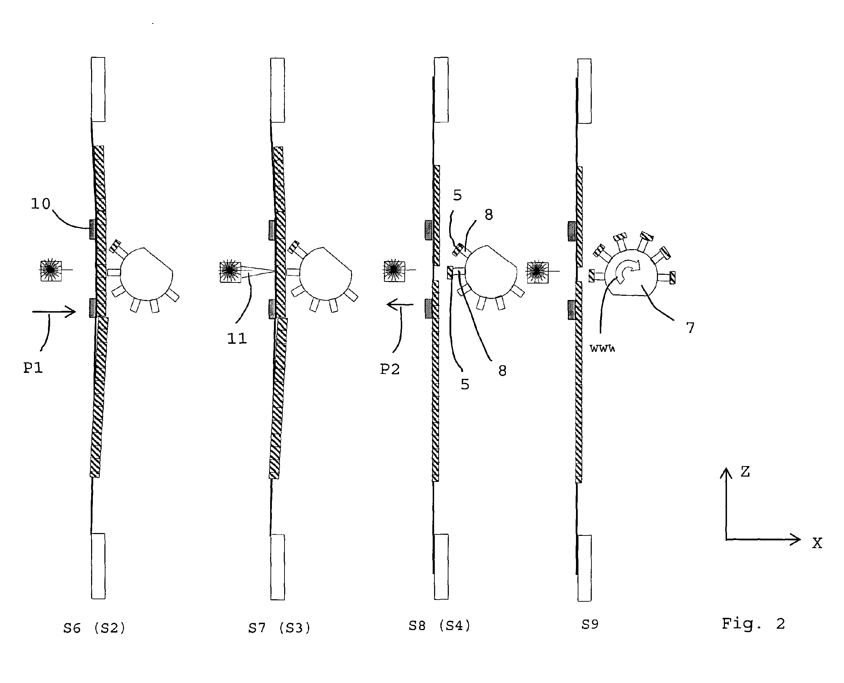

Figure 2 shows in a number of steps S1-S9 the detachment and removal of components 5 from a component carrier 1. As step S1 clearly shows, the component carrier 1 is moved in vertical direction, with the plane of the component carrier 1 extending in the Y-Z plane. An element 7, which is rotatable about an axis of rotation 6, is positioned opposite the wafer 4, which element is provided with nozzles 8 extending transversely to said axis of rotation 6. Disposed on a side of the component carrier 1 remote from the element 7 is an energy source 9 comprising a laser, an optical axis 9' of which energy source intersects the axis of rotation 6. Arranged symmetrically relative to the energy source 9 is a ring 10, which abuts against the film 3 on a side remote from the components 5. The central axis of the ring 10 extends transversely to the film 3. The component carrier 1 is so positioned between the energy source 9 and the element 7 that a component 5 is present between the energy source 9 and the nozzle 8 directed towards the film 3.

To pick up said component 5, the ring 10 is moved in the direction indicated by the arrow P1 (step S2), until the component 5 abuts against the nozzle 8. The adhesive bond between the component 5 and the film 3 is thus placed in the focal plane of the energy source 9 as well. Then a partial vacuum is generated in the nozzle 8, causing the component 5 to be sucked against the nozzle 8. Moving the ring 10 in the direction indicated by the arrow P1 causes the film 3 to be deformed, as a result of which the components 5 located within and around the ring 10 are moved slightly apart.

After the component 5 has been pressed against the nozzle 8, the energy source 9 is activated (step S3), as a result of which a laser beam 11 is directed at the adhesive bond between the film 3 and the component 5. Using the laser beam 11, a highly concentrated amount of energy can be introduced into the adhesive bond. Said energy causes the adhesive bond to be broken and the component 5 to be shot in the direction of the nozzle 8, as it were. Because the nozzle 8 abuts against the component 5, however, undesirable movement of the component 5 is prevented in an effective manner. After a relatively short time of 10-15 milliseconds, depending inter alia on the dimension and the thickness of the component 5, the energy source 9 is turned off and the ring 10 is moved in the direction indicated by the arrow P2, opposite the direction indicated by the arrow P1. The component 5 remains connected to the nozzle 8, however (step S4).

Following that, the element 7 is rotated about the central axis 6 in the direction indicated by the arrow β until a next nozzle 8 is directed towards the film 3. The component carrier 1 is moved, so that a new component 5 is positioned between the nozzle 8 and the energy source 9. Subsequently, the steps S2, S3, S4 are repeated. This is shown in the figure as steps S6, S7 and S8. Then the element 7 is rotated in the direction indicated by the arrow β again and another nozzle 8 not provided with a component 5 yet is positioned opposite the film 3. The steps S1-S4 are repeated until all the nozzles 8 are provided with a component 5 (step S9).

Then the element 7 can be moved to a position above a substrate, after which the components 5 can be successively placed at different positions on the substrate. It is also possible, however, for the components 5 to be successively placed on different substrates.

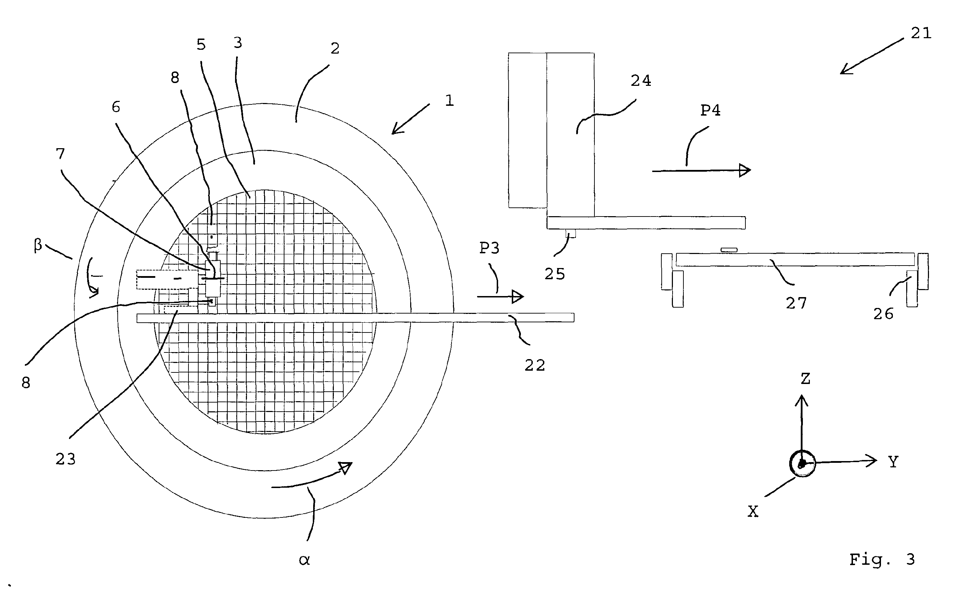

According to another possibility, the components 5 on the element 7 are taken over by another nozzle, by means of which nozzle the component 5 is subsequently placed on a substrate. This embodiment will be explained in more detail with reference to figures 3-10.

The device 21 shown in figure 3 comprises a holder for the component carrier 1, by means of which the component carrier 1 can be rotated about the X-axis in the direction indicated by the arrow α. The device 21 is further provided with a guide 22 extending in the Y-direction and with a slide 23 which is movable over the guide 22 in the direction indicated by the arrow P3 and in the opposite direction. The slide 23 is provided with an element 7 which is rotatable about the Y-axis in the direction indicated by the arrow β. The element 7 is identical to the element 7 that is shown in figure 2. The nozzles 8 of the element 7 extend in the X-Z plane.

The device 21 further comprises a component placement unit 24 being movable in the Y-direction, which is provided with a nozzle 25. The nozzle 25 extends in the Z-direction. The slide 24 is movable in the direction indicated by the arrow P4 and in the opposite direction. The device 21 further comprises a substrate carrier 26 for supporting a substrate 27 and for moving the substrate 27 in the X-direction.

In the situation shown in figure 3, components 5 are picked up from the component carrier 1 in the manner shown in figure 2 by means of nozzles 8. For each component, a nozzle 8 not provided with a component yet is positioned opposite a position on the film 3 where a component 5 is still present by rotating the component carrier 1 in the direction indicated by the arrow a and moving the slide 23 in the direction indicated by the arrow P3. Simultaneously with the moving of the slide 23 in the direction indicated by the arrow P3 or in the opposite direction, an energy source 9 disposed on the other side of the component holder 1 is moved in a similar manner as the slide 23 by means of a separate drive unit.

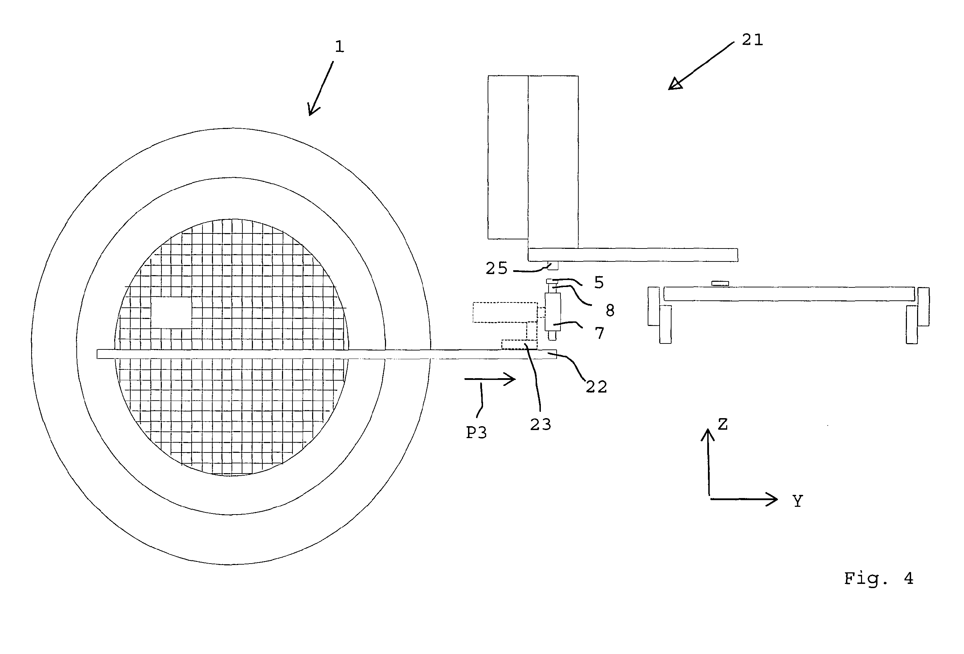

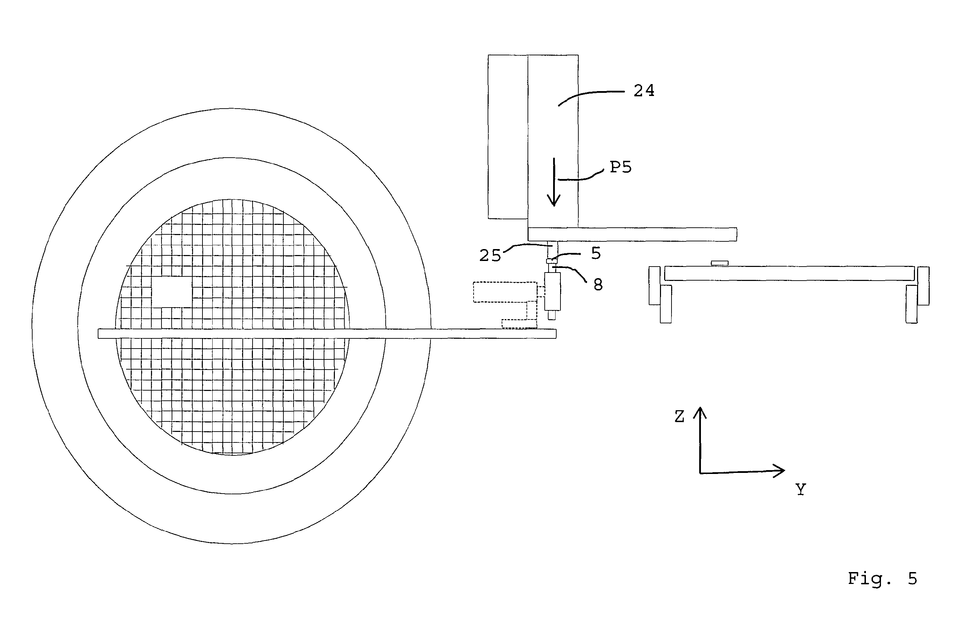

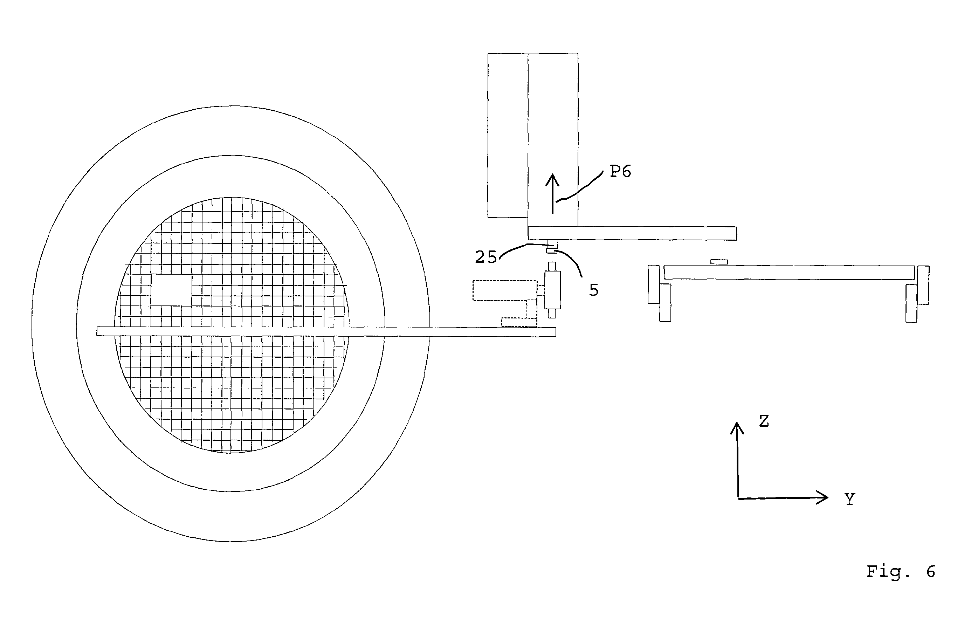

Once all the nozzles 8 are provided with components 5, the slide 23 is moved over the guide 22 in the direction indicated by the arrow P3, as shown in figure 4, until the nozzles 8 lie in the same plane as the nozzle 25. The element 7 is rotated in the direction indicated by the arrow β until a nozzle 8 is in line with the nozzle 25. Following that, as shown in figure 5, the nozzle 25 is moved in downward Z-direction with respect to the component placement unit 24. Said movement indicated by the arrow P5 continues until the nozzle 25 abuts against a side of the component 5 remote from the nozzle 8. The nozzle 25 engages the component 5 via a partial vacuum. Once a partial vacuum is being applied to the component 5 by means of the nozzle 25, the partial vacuum applied to the component 5 by the nozzle 8 is released and the nozzle can be moved in the direction indicated by the arrow P6, opposite the direction indicated by the arrow P5, as shown in figure 6, thereby moving the component 5 in that direction as well.

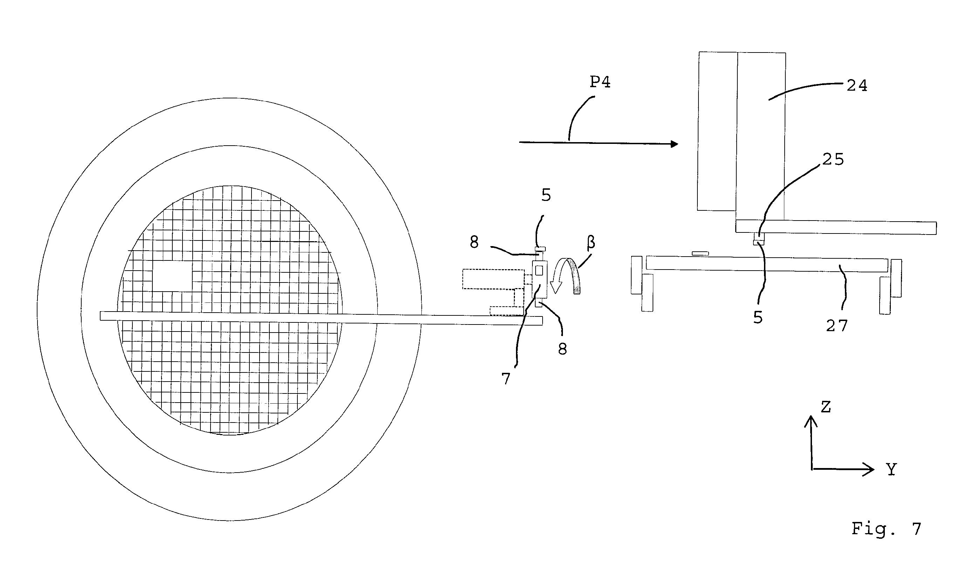

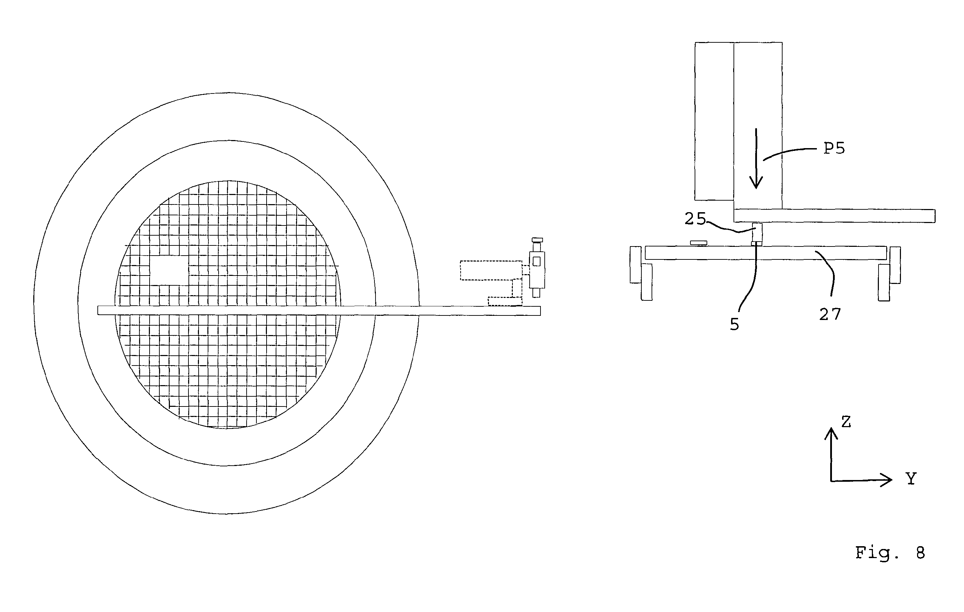

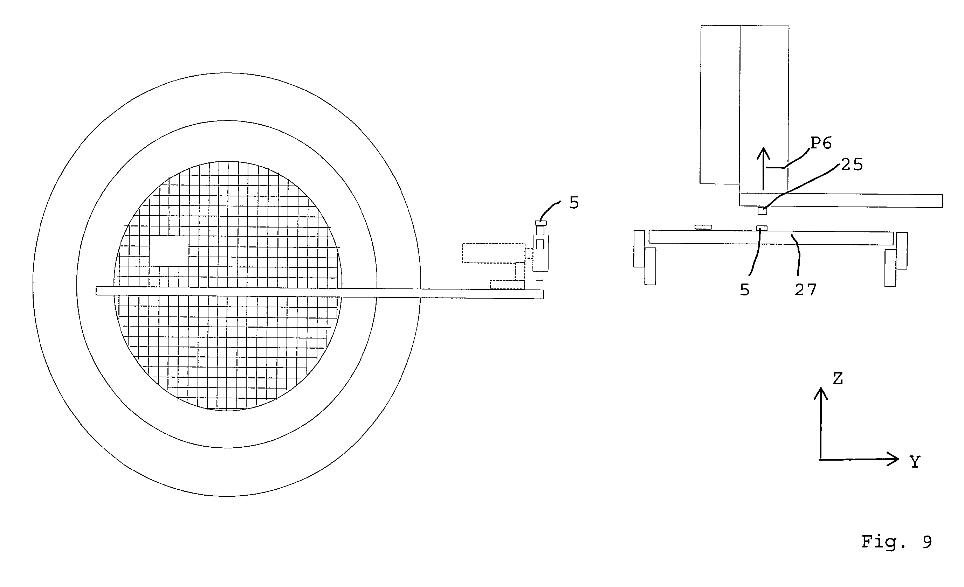

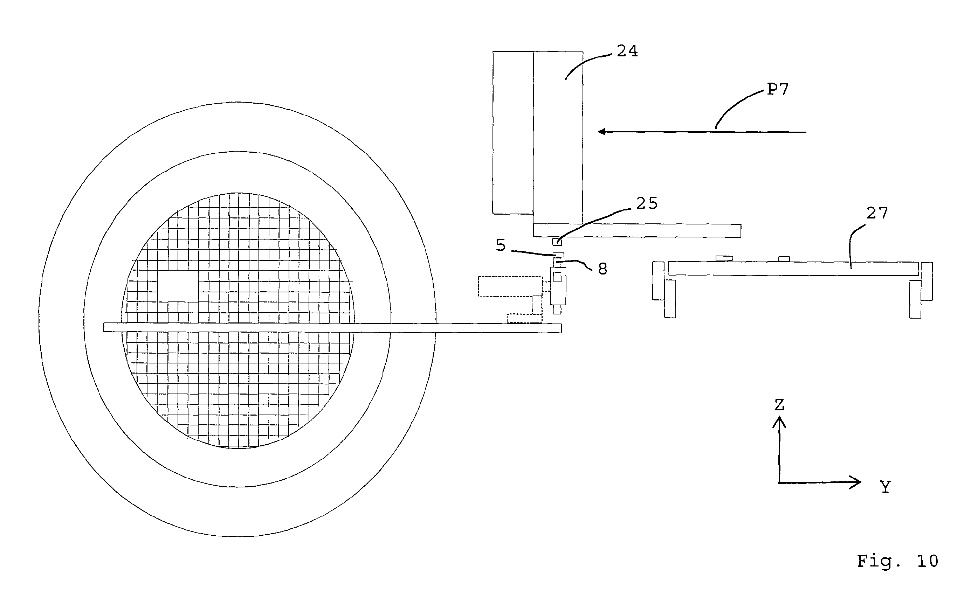

Following that, the component placement unit 24 is moved in the direction indicated by the arrow P4 to a position above the substrate 27 where the component 5 is to be placed on the substrate 27 (figure 7). Then the nozzle 25 is moved in the direction indicated by the arrow P5, as a result of which the component 5 is positioned on the substrate 27 (figure 8). During the moving the component placement unit 24 and the placing of the component 5 on the substrate 27, the element 7 is rotated in the direction indicated by the arrow β, so that a nozzle 8 provided with a component 5 is moved to a position where the component 5 can be picked up by means of the nozzle 25. After the component 5 has been positioned on the substrate 27, the nozzle 25 is moved in the direction indicated by the arrow P6 (figure 9), whereupon the component placement unit 24 is moved in a direction indicated by the arrow P6, opposite the direction indicated by the arrow P4, to a position in which the nozzle 25 is positioned opposite the nozzle 8. This situation, which is shown in figure 10, corresponds to the situation shown in figure 4. Then the picking up of a component 5 by means of the nozzle 25, the placement thereof on the substrate 27 and the picking up of a component 5 again by means of the nozzle 25 from the nozzle 8 is repeated until all the components 5 supported by nozzles 8 have been positioned on one or several substrates 27. Subsequently the slide 23 is moved to a position opposite the component carrier 1 again, and new components 5 can be picked up from the component carrier 1.

In the case of a horizontally positioned component carrier 1, it is also possible to pick up components 5 directly by means of the nozzle 25 and place them on the substrate 27.

## Claims

1. A method for picking up a component from a film, which component is connected to the film by means of an adhesive bond, which adhesive bond between the component and the film is irradiated by means of an energy beam, after which the component is picked up from the film by means of a nozzle, **characterised in that** prior to the irradiation of the adhesive bond by means of the energy beam, the nozzle is placed into contact with the component on a side remote from the film by moving part of the film in the direction of the nozzle, after which the energy beam, which comprises a laser beam, is activated, so that the adhesive bond between the component and the film is irradiated by the energy beam and the adhesive bond is at least substantially completely broken.

2. A method according to claim 1, **characterised in that** the component is pushed away from the film, into contact with the nozzle, as a result of the laser beam being activated.

3. A method according to claim 1 or 2, **characterised in that** the laser beam is activated for 10-50 milliseconds, during which period 10-20 Watt is introduced into the adhesive bond.

4. A method according to any one of the preceding claims, **characterised in that** a number of components are picked up in succession by means of a number of nozzles, after which the components are placed on at least one substrate.

5. A device suitable for carrying out a method according to any one of the preceding claims, which device comprises a carrier for a film provided with components, which components are connected to the film by means of an adhesive bond, which device further comprises a nozzle for picking up a component from the film as well as a light source for generating an energy beam for irradiating the adhesive bond, **characterised in that** said light source is a laser for generating a laser beam, which device further comprises a ring extending around a central axis, which can be positioned on a side of the film remote from the components, with the central axis extending substantially transversely to the film, which ring is movable in a direction parallel to said central axis.

6. A device according to claim 5, **characterised in that** the device comprises an element which is rotatable about an axis of rotation, which element comprises a number of nozzles extending transversely to the axis of rotation.
